# EUROPEAN PATENT APPLICATION

(11) **EP 4 135 053 A1**
(43) Date of publication of application: **15.02.2023**
(21) Application number: 22165716.6
(22) Date of filing: 30.03.2022
(51) Int. Cl.: H01L 29/78, H01L 29/417, H01L 29/06, H01L 29/12

(54) **TRANSISTOR DEVICE AND METHOD FOR PRODUCING THEREOF**

(30) Priority: 13.08.2021 DE 102021121138
(71) Applicant: Infineon Technologies AG, 85579 Neubiberg (DE)
(72) Inventor: LEENDERTZ, Caspar, 81669 München (DE); SIEMIENIEC, Ralf, 9500 Villach (AT)
(74) Representative: Westphal, Mussgnug & Partner, Patentanwälte mbB

(57) **Abstract**

A transistor device and a method for producing thereof are disclosed. The transistor device, includes a SiC semiconductor body (100) that includes a first semiconductor layer (110); a plurality of trenches (2) each extending from a first surface (111) of the first semiconductor layer (110) into the first semiconductor layer (110); and a plurality of transistor cells (1) each coupled to a source node (S). The first semiconductor layer (110) includes a plurality of mesa regions (112) each formed between two neighboring ones of the trenches (2), in each of the mesa regions (112), at least one of the plurality of transistor cells (1) is at least partially integrated, each of the transistor cells (1) is connected to the source node (S) via a respective source contact (4), and each of the source contacts (4) is arranged in a respective one of the trenches (2) and is spaced apart from a bottom (2₃) of the respective trench (2).

## Description

This disclosure relates in general to a transistor device, in particular a transistor device that is based on a silicon carbide (SiC) semiconductor body.

Because of offering low switching losses at high voltage blocking capabilities semiconductor devices, such as transistor devices, made of Silicon Carbide (SiC) are becoming more and more popular in power electronics applications, such as power conversion and drive applications.

A SiC semiconductor body, however, is prone to bipolar degradation. Bipolar degradation may occur when a recombination of electrons and holes takes place at crystal defects in the semiconductor body of the device. Crystal defects may include basal plane dislocations or stacking faults, for example. The energy associated with the recombination of electrons and holes may cause the crystal defects to further expand in the semiconductor body, so that a large defect region may occur. A large defect region, however, may degrade the device properties, such as increase the on-resistance and increase the leakage current in the transistor device.

Major polytypes of SiC are 4H-SiC, 6H-SiC, and 3C-SiC, wherein SiC of the 4H or 6H polytype is mainly used in the production of semiconductor devices. SiC of the 4H or 6H polytype is thermodynamically metastable. Crystal defects that may occur based on the recombination of electrons and holes include, for example, a local transformation of 4H-SiC or 6H-SiC into 3C-SiC.

There is a need to provide a SiC based transistor device with a low specific on-resistance Ron·A, wherein Ron is the electrical resistance of the transistor device in the on-state and A is the area of a semiconductor body in which active regions of the transistor device are integrated.

One example relates to a transistor device. The transistor device includes a SiC semiconductor body that includes a first semiconductor layer, a plurality of trenches each extending from a first surface of the first semiconductor layer into the first semiconductor layer, and a plurality of transistor cells each coupled to a source node. The first semiconductor layer includes a plurality of mesa regions each formed between two neighboring ones of the trenches, wherein, in each of the mesa regions, at least one of the plurality of transistor cells is at least partially integrated. Furthermore, each of the transistor cells is connected to the source node via a respective source contact, and each of the source contacts is arranged in a respective one of the trenches and is spaced apart from a bottom of the respective trench.

Another example relates to a method. The method includes forming a plurality of trenches in a first semiconductor layer of a SiC semiconductor body, each trench extending from a first surface of the first semiconductor layer into the first semiconductor layer, and forming source contacts, wherein each source contact is arranged in a respective one of the trenches and is spaced apart from a bottom of the respective trench. The method further includes forming a plurality of transistor cells such that each transistor cell is coupled to a source node via a respective source contact and such that each transistor cell is at least partially integrated in a respective one of a plurality of mesa regions each formed between two neighboring ones of the trenches.

Examples are explained below with reference to the drawings. The drawings serve to illustrate certain principles, so that only aspects necessary for understanding these principles are illustrated. The drawings are not to scale. In the drawings the same reference characters denote like features.
Figure 1 schematically illustrates a vertical cross sectional view of one example of a semiconductor device that includes trenches arranged in a first semiconductor layer and a plurality of transistor cells at least partially integrated in the first semiconductor layer;
Figure 2 illustrates one example of a semiconductor device that further includes a second semiconductor layer;
Figure 3 illustrates a top view of one section of the semiconductor body according to one example, wherein the trenches are elongated trenches;
Figure 4 illustrates a top view of one section of the semiconductor body according to another example, wherein the trenches are needle trenches (spicular trenches);
Figure 5 illustrates a top view of the entire semiconductor body according to one example;
Figures 6 - 8 illustrate different examples of the trenches;
Figure 9 illustrates one example of a transistor cell that includes a gate electrode;
Figure 10 schematically illustrates a top view of one section of a semiconductor device according to an example in which the trenches are elongated trenches and the gate electrodes of the transistor cells are elongated gate electrodes;
Figure 11 schematically illustrates a top view of one section of a semiconductor device according to an example in which the trenches are needle trenches and the gate electrodes of the transistor cells form a rectangular grid;
Figure 12 schematically illustrates a top view of one section of a semiconductor device according to an example in which the trenches are needle trenches and the gate electrodes of the transistor cells form a hexagonal grid;
Figures 13 - 18 illustrate different further examples of transistor cells;
Figures 19A - 19C illustrate one example of a method for forming source and body regions of a transistor cell;
Figures 20A - 20B illustrate one example of a method for forming a JFET region, wherein the method includes implanting dopant atoms into a first surface of the first semiconductor layer;
Figures 21A - 21C illustrate another example of a method for forming a JFET region, wherein the method includes implanting dopant atoms into a first surface of the first semiconductor layer;
Figures 22A - 22B illustrate an example of a method for forming a JFET region, wherein the method includes implanting dopant atoms into a sidewall of a trench formed in the first semiconductor layer;
Figures 23A - 23C illustrate another example of a method for forming a JFET region, wherein the method includes implanting dopant atoms into a first surface of the first semiconductor layer;
Figures 24A - 24C illustrate one example of a method for forming a lateral extension of a trench formed in the first semiconductor layer;
Figure 25 illustrate one example of a method for implanting dopant atoms into a trench sidewall, wherein the method uses a protection layer that partially covers the sidewall;
Figures 26A - 26D illustrate one example of a method for forming the protection layer;
Figure 27 illustrates one example of a method for implanting dopant atoms into a trench sidewall as a basis for forming a compensation region;
Figure 28 illustrates one example of a method for implanting dopant atoms into a trench sidewall as a basis for forming a drift region;
Figure 29 illustrates one example of a method for forming the trenches; and
Figures 30A - 30H illustrate one example of a method for forming a trench structure of the type shown in Figure 6.

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

One example explained in the following relates to a transistor device. The transistor device includes a SiC semiconductor body that includes a first semiconductor layer, a plurality of trenches each extending from a first surface of the first semiconductor layer into the first semiconductor layer, and a plurality of transistor cells each coupled to a source node. The first semiconductor layer includes a plurality of mesa regions each formed between two neighboring ones of the trenches, wherein, in each of the mesa regions, at least one of the plurality of transistor cells is at least partially integrated. Furthermore, each of the transistor cells is connected to the source node via a respective source contact, and each of the source contacts is arranged in a respective one of the trenches and is spaced apart from a bottom of the respective trench.

According to one example, at least some of the plurality of trenches include a cavity between the respective trench bottom and the source contact. In this case, a dielectric layer may be formed between the cavity and the source contact. A pressure in the cavity is lower than 0.1 bar or lower than 0.01 bar, for example. According to one example, the transistor device further includes a further dielectric layer formed between the cavity and semiconductor material of the semiconductor body.

According to another example, at least some of the trenches are filled with a solid dielectric between the respective trench bottom and the source contact.

According to one example, the semiconductor body further includes a second semiconductor layer, wherein at least a section of the second semiconductor layer forms a drain region of the transistor device, and wherein the first semiconductor layer is formed on top of the second semiconductor layer. The trenches may extend through the first semiconductor layer into the second semiconductor layer.

According to one example, each transistor cell of the transistor device includes, a source region connected to the source contact, a body region adjoining the source region, a drift region, and a gate electrode arranged adjacent to the body region and dielectrically insulated from the body region by a gate dielectric. According to one example, the drift region adjoins the body region. According to another example, the drift region is spaced apart from the body region, and a current spreading region of the same doping type as the drift region is arranged between the drift region and the body region. According to one example, the body region adjoins the source contact. The drift region is an implanted region, for example.

According to one example, each transistor cell includes a compensation region arranged adjacent to the drift region and connected to the source contact. The compensation region may adjoin the source contact.

According to one example, each transistor cell includes a JFET region of the same doping type as the body region and more highly doped than the body region. The JFET region is spaced apart from the gate dielectric and adjoins at least one of the drift region and the current spreading region. The JFET region may adjoin the source contact. In a transistor device that includes a compensation region, the compensation region may be connected to the source contact through the JFET region. According to one example, the JFET region adjoins the source contact, and the body region is connected to the source contact through the JFET region.

Another example explained in the following relates to a method. The method includes forming a plurality of trenches in a first semiconductor layer of a SiC semiconductor body, each trench extending from a first surface of the first semiconductor layer into the first semiconductor layer, and forming source contacts, wherein each source contact is arranged in a respective one of the trenches and is spaced apart from a bottom of the respective trench. The method further includes forming a plurality of transistor cells such that each transistor cell is coupled to a source node via a respective source contact and such that each transistor cell is at least partially integrated in a respective one of a plurality of mesa regions each formed between two neighboring ones of the trenches.

According to one example, the semiconductor body further includes a second semiconductor layer, wherein at least a section of the second semiconductor layer forms a drain region of the transistor device, and wherein the first semiconductor layer is formed on top of the second semiconductor layer. The trenches may be formed to extend through the first semiconductor layer into the second semiconductor layer.

According to one example, forming each transistor cell includes forming a source region connected to the source contact, and forming a body region adjoining the source region. Forming the source region includes forming a first implanted region by implanting dopant atoms via the first surface into the first semiconductor layer, forming the body region includes forming a second implanted region by implanting dopant atoms via the first surface into the first semiconductor layer, and forming the source region and the body region further includes an annealing process.

According to one example, forming each transistor cell further includes forming a JFET region, and forming the JFET region includes forming a third implanted region by implanting dopant atoms into the first semiconductor layer. According to one example, implanting the dopant atoms to form the third implanted region includes implanting the dopant atoms via the first surface into the first semiconductor layer. According to another example, implanting the dopant atoms to form the third implanted region includes implanting the dopant atoms via a sidewall of a respective one of the trenches into the first semiconductor layer. Implanting the dopant atoms via the sidewall may include partially covering the sidewall by a protection layer.

According to one example, forming the source region and forming the JFET region includes forming the source region and the JFET region such that the source region extends along the JFET region to the source contact.

According to one example, forming the source contact includes forming a lateral extension that extends from the trench to the source region.

According to one example, forming each transistor cell further includes forming a compensation region. Forming the compensation region includes forming a fourth implanted region by implanting dopant atoms via a sidewall of a respective one of the trenches into the first semiconductor layer.

According to one example, each transistor cell further includes a drift region. According to one example, the first semiconductor layer has a basic doping concentration, and the drift region is a semiconductor region having the basic doping concentration of the first semiconductor layer. According to another example, forming the drift region includes forming a fifth implanted region by implanting dopant atoms via a sidewall of a respective one of the trenches into the first semiconductor layer.

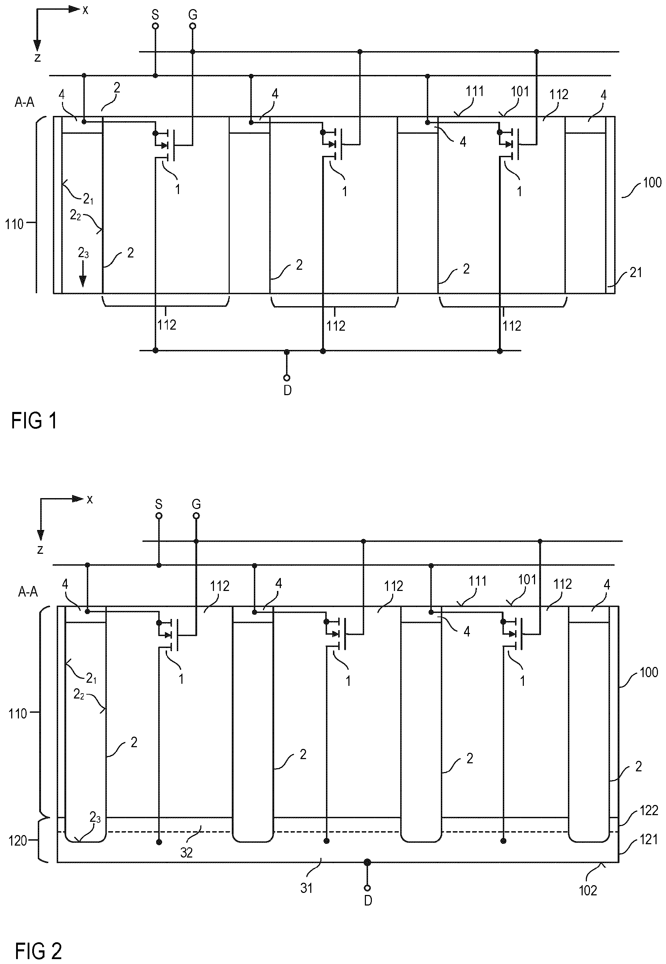

Figure 1 schematically illustrates one example of a semiconductor device, in particular, a transistor device. The transistor device includes a SiC semiconductor body 100. According to one example, the semiconductor body 100 is a 4H-SiC or 6H-SiC semiconductor body 100. The semiconductor body 100 includes a first semiconductor layer 110 and a first surface 101 that is formed by a first surface 111 of the first semiconductor layer 110. Figure 1 shows a vertical cross sectional view of the semiconductor body 100 in a section plane that is perpendicular to the first surface 101. This section plane is also referred to as vertical section plane in the following.

The transistor device further includes a trench structure with a plurality of trenches 2 that each extend from the first surface 101 of the semiconductor body 100 into the first semiconductor layer 110, and a plurality of mesa regions 112. A "mesa region" is a section of the first semiconductor layer 110 that is arranged between two neighboring ones of the trenches 2.

Referring to Figure 1, the transistor device further includes a plurality of transistor cells 1, wherein in each of the mesa regions 112 at least one of the plurality of transistor cells 1 is at least partially integrated. "At least partially integrated" includes that sections of the transistor cells 1 may be formed in the mesa regions 112 and other sections may be formed on top of the first semiconductor layer 110, for example. In Figure 1, the one or more transistor cells that are at least partially integrated in each mesa region 112 are represented by the circuit symbol of a transistor. The circuit symbols illustrated in Figure 1 each represent an n-type enhancement MOSFET. This, however, is only an example and is only for the purpose of illustration. Basically, transistor cells of any type of transistor device may be integrated (at least partially) in the mesa regions 112.

The transistor device includes a source node S, which is only schematically illustrated in Figure 1. Each of the transistor cells is connected to the source node via a respective source contact 4, wherein each of the source contacts 4 is arranged in a respective one of the trenches 2. Furthermore, each source contact 4 is spaced apart from a bottom 2₃ (not shown in Figure 1) of the respective trench 2, so that in a vertical direction z of the semiconductor body 100, the trenches 2 extend deeper into the first semiconductor layer 110 than the source contacts 4.

Forming the source contacts 4 in the trenches 2 makes it possible to produce the semiconductor device in a space efficient way.

Figure 2 shows one example of a transistor device of the type shown in Figure 1 in greater detail. Referring to Figure 2, the transistor device may further include a second semiconductor layer 120 which forms a second surface 102 opposite the first surface 101 of the semiconductor body 100. The first semiconductor layer 110 is formed on top of the first second semiconductor 120. The second semiconductor layer 120 may include a drain region 31 of the transistor device, wherein the drain region 31 is connected to a drain node D, which is only schematically illustrated in Figure 2. In addition to the drain region 31, the second semiconductor layer 120 may include a buffer region 32, wherein the buffer region 32 is arranged between the drain region 31 and the first semiconductor layer 110 and has a lower doping concentration than the drain region 31.

According to one example, the drain region 31 is formed by a semiconductor substrate 121 and the buffer region 32 is formed by an epitaxial layer 122 grown on top of the substrate 111. According to one example, a doping concentration of the substrate 121 and, therefore, the doping concentration of the drain region 31 is between 1E18 cm⁻³ and 1E20 cm⁻³. According to one example, the doping concentration of the buffer region 32 is between 1E18 cm⁻³ and 8E18 cm⁻³.

According to one example, the first semiconductor layer 110 is an epitaxial layer that is either grown on the substrate 121 (when the buffer region 32 is omitted) or on the epitaxial layer 122 forming the buffer region 32. The first semiconductor layer 110 may be implemented in various ways (1) According to one example, the first semiconductor layer 110 is in-situ doped during the epitaxial growth process such that the first semiconductor layer 110 has a basic doping concentration that corresponds to a desired doping concentration of an active region of the transistor cells 1. The active region is a drift region 11, which is explained herein further below, for example. The basic doping concentration formed in the epitaxial growth process is selected from between 5E15 cm⁻³ and 8E17 cm⁻³, for example. (2) According to another example, the first semiconductor layer 110 is formed such that the basic doping concentration is lower than the desired doping concentration of any of the active regions. In this case, the first epitaxial layer 110 may be an intrinsic layer. This includes that the first semiconductor layer 110 is not intentionally doped during the epitaxial growth process, so that a doping concentration is lower than 5E15 cm⁻³ or even lower than 1E15 cm⁻³.

According to one example, a thickness of the first semiconductor layer 110, which is the (shortest) dimension of the first semiconductor layer 110 in the vertical direction z between the first surface 101 and the second semiconductor layer 120, is between 3 micrometers and 60 micrometers.

As illustrated in Figure 2, the trenches 2 may extend through the first semiconductor layer 110 and into the second semiconductor layer 120. According to one example, the trenches 2 extend between 500 nanometers and 8 micrometers into the second semiconductor layer 120. That is, a distance between the trench bottom 2₃ and an interface between the first semiconductor layer 110 and the second semiconductor layer 120 is between 500 nanometers (0.5 micrometers) and 8 micrometers. However, the trenches 2 extending into the second semiconductor layer 120 is only an example. According to another example explained herein further below the trenches 2 terminate in the first semiconductor layer 110 spaced apart from the second semiconductor layer 120.

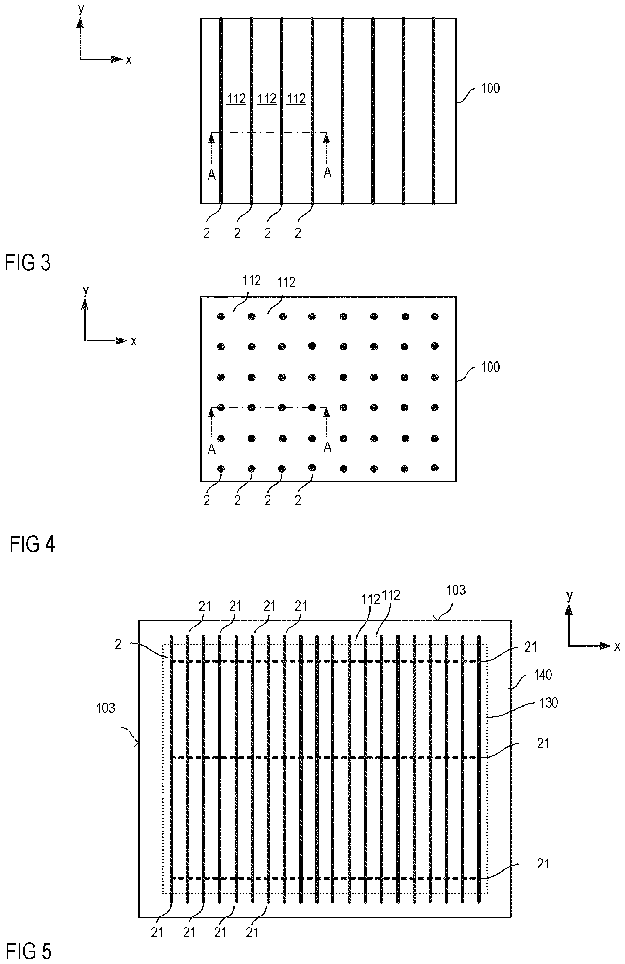

The semiconductor body 100 includes a horizontal plane, which is a plane that includes first and second lateral directions x, y and is parallel to the first and second surfaces 101, 102. In the horizontal plane, the trenches 2 may be implemented as illustrated in Figures 3 and 4, for example. Each of Figures 3 and 4 shows a top view of one section of the semiconductor body 100. For the ease of illustration, only the trenches are shown in Figures 3 and 4.

In the example shown in Figure 3, the trenches 2 are elongated trenches that are essentially parallel to each other and are spaced apart from each other in the first lateral direction x. Longitudinal directions of the trenches 2 correspond to the second lateral direction y. According to one example, "elongated" includes that a length of the trenches 2, which is dimension of the trenches 2 in the longitudinal direction, is significantly greater than a width, which is a dimension in a direction perpendicular to the longitudinal direction. According to one example, the length is at least 10 times, at least 100 times, or at least 1000 times the width.

According to one example, the trenches 2 are formed such that a (shortest) distance between neighboring elongated trenches is between 0.8 micrometer and 5 micrometers, in particular between 1 micrometer and 3 micrometers. Elongated trenches 2 that are spaced apart from each other in the first lateral direction x are also referred to as first trenches in the following.

In the example shown in Figure 4, the trenches 2 are needle-shaped trenches (spicular trenches) or, briefly, needle trenches. According to one example, needle trenches are trenches in which a dimension in the first lateral direction x is in the same order of magnitude as a dimension in the second lateral direction y. According to one example, dimensions in the first and second lateral directions are essentially the same. "Essentially" includes that the dimension in one of the first and second directions x, y deviates less than 20% from the dimension in the other one of the first and second directions x, y. In the horizontal plane, needle trenches 2 may be rectangular, circular (as illustrated in Figure 4), hexagonal, or the like.

Elongated trenches 2, in particular, may help to avoid or at least reduce bipolar degradation. Bipolar degradation is associated with a propagation of crystal defects, such as basal plane dislocations or stacking faults, in the crystal of the semiconductor body 100. Such defects may occur, in particular when the transistor device operates in a bipolar mode. The transistor device is in a bipolar mode, for example, when an internal body diode is contacting. The latter is explained herein further below. A trench structure with elongated trenches 2 reduces the expansion of such crystal defects as it prevents crystal defects that are generated in one of the mesa regions 112 to propagate into other ones of the mesa regions 112.

The implementation of needle trenches 2 requires less space than the implementation of elongated trenches 2. Thus, at a given size of the semiconductor body 100, implementing the transistor device with needle trenches 2 may result in a lower on-resistance than implementing the transistor device with elongated trenches 2.

In each case, the trenches 2 may be used for producing certain regions of the transistor cells 1, such as compensation or drift regions. This is explained in detail herein further below.

Figure 5 illustrates a top view of the entire semiconductor body 100. Referring to Figure 5, the semiconductor body 100 may include an inner region 130, wherein the inner region is a region in which the transistor cells 1 (not shown in Figure 5) are integrated. In addition to the inner region 130, the semiconductor body 100 may include an edge region 140, wherein the edge region 140 is arranged between the inner region 130 and an edge surface 103 of the semiconductor body 100. The edge surface 103 terminates the semiconductor body 100 in the first and second lateral directions y, x, and the edge region 140 surrounds the inner region 130 in the horizontal plane.

Just for the purpose of illustration, in the example shown in Figure 5, the trenches 2 are elongated trenches 2. Referring to Figure 5, the parallel (first) trenches 2 may extend entirely across the inner region 130 and into the edge region 140, wherein longitudinal ends of the trenches 21 are spaced apart from the edge surface 103. In this example, the trench structure with the trenches 2 does not entirely separate the mesa regions 112 from one another.

Optionally, the trench structure includes several additional trenches 2 (illustrated in dashed lines). These trenches 2, which are referred to as second trenches in the following, cross the first trenches 2 so that at least some mesa regions 121 are formed that are entirely surrounded by trench sections, sections of two parallel first trenches and sections of two parallel second trenches. Providing the second trenches 21 results in smaller mesa regions, as compared to a scenario in which the trench structure 2 only includes first trenches 21. Smaller mesa regions help to further reduce the risk of bipolar degradation. According to one example, a (shortest) distance in the second lateral direction y between neighboring second trenches is significantly larger than a (shortest) distance between neighboring first trenches in the first lateral direction. According to one example the distance between neighboring second trenches is at least 10 times the distance between neighboring first trenches.

In the examples shown in Figure 5, the trench structure mainly includes first trenches 2. "Mainly", as used herein, includes that (a) the trench structure only includes first trenches 2; or (b) includes second trenches 2 in addition to the first trenches 2, wherein the number of second trenches is significantly lower than the number of first trenches 2. The number of second trenches is less than 10% or even less than 1% of the number of first trenches, for example.

In the example shown in Figure 5, the optional second trenches 2 are perpendicular to the first trenches 2, so that the second trenches longitudinally extend in the first lateral direction x. This, however, is only an example. According to another example, angles between the first and second trenches 2 are between 45° and 90°.

In the following, unless explicitly stated otherwise, trenches 2 illustrated in the drawings are first trenches, which are parallel trenches that are spaced apart in the first lateral direction x and longitudinally extend in the second lateral direction y, or trenches 2 illustrated in the drawings are needle trenches.

When the trenches 2 are elongated trenches each of the trenches 2 is arranged between two neighboring mesa regions 112, and each of the mesa regions 112 is defined by at least two of the trenches 2. Each trench 2 has a depth d, a width w, and a length 1. The trench depth d is the dimension of the respective trench 2 in the vertical direction z. The trench width w is the dimension in the direction in which parallel trenches 2 are spaced apart from each other, which is the first lateral direction x in the examples Figures 1 and 2. The trench length is the dimension in the longitudinal direction of the trench 2, which is the second lateral direction y in the examples shown in Figures 1 and 2. According to one example, the width w is smaller than the length 1. According to one example, the length 1 is at least 10 times, at least 100 times, or at least 1000 times the width w.

When the trenches 2 are needle trenches, the mesa regions 112 form a contiguous semiconductor region that surrounds the trenches 2 in lateral directions. In the following, the width w of a needle trench denotes the (maximum) dimension of the trench in the first lateral direction x. Referring to the above, in the second lateral direction y, the dimension of the trench is in the same order of magnitude than in the first lateral direction x.

In each case, the mesa regions 112 are formed by sections of the semiconductor layer 110 that, in lateral directions, are located between the trenches 2. In the event that the trenches 2 do not extend into second semiconductor layer 120, the mesa regions 112, in the vertical direction, extend as deep as the trenches 2.

Furthermore, in each case, the trench width w is the distance between opposite trench sidewalls 2₁, 2₂ or trench sidewall sections (in a needle trench, for example) of each trench 2. In the examples shown in Figures 1 and 2, the trenches 2 are drawn to have vertical sidewalls, so that the distance between the sidewalls 2₁, 2₂ is essentially the same at each vertical position of trench 2. This, however, is only an example. According to another example, the trenches 2 have beveled sidewalls such that the distance between the sidewalls 2₁, 2₂ either decreases or increases towards the trench bottom 2₃. The trench bottom 2₃ terminates the respective trench 2 in the vertical direction z. In the following, the width w of a trench 2 denotes the average distance between the first and second sidewalls 2₁, 2₂.

According to one example, the trenches 2 are formed such that an aspect ratio, which is a ratio between the depth d and the width w is selected from between 25:1 and 5:1, in particular between 15:1 and 5:1. According to one example, the trenches are formed such that the width w is between 500 nanometers and 3 micrometers. In the event that the trenches 2 have beveled sidewalls, the aspect ratio is the ratio between the trench depth d and an average trench width.

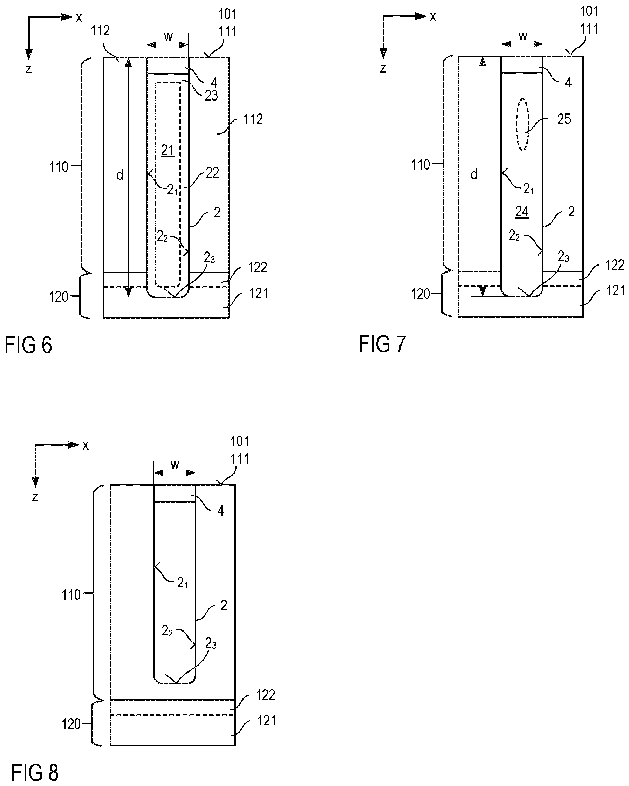

The trenches 2 may be implemented in various ways. Some examples for implementing the trenches 2 are schematically illustrated in Figures 6 - 8 and are explained in the following. In each of Figures 6 - 8 only one trench 2 is illustrated. In the transistor device, the plurality of trenches 2 may be in accordance with only one of the examples according to Figures 6 - 8. According to another example, different types of the trenches may be arranged in the same transistor device.

Referring to Figure 6, the trench 2 may include a cavity 21 between the trench bottom 2₃ and the source contact 4. The source contact 4 may have the form of a contact plug and closes the trench 2. Optionally, a dielectric layer 22 (illustrated in dashed lines in Figure 6) is arranged between the cavity 21 and the mesa regions 112. A further dielectric layer 23 may be arranged between the cavity 21 and the source contact 4. The dielectric layers 22, 23 are oxide layer, for example.

According to one example, the trenches 2 are vacuum trenches. That is, a pressure in the cavity 21 is significantly lower than atmospheric pressure, which is about 1 bar (≈ 1013hPa). According to one example, the pressure in the cavity 21 is less than 1%, less than 0.1 %, or even less than 0.01 % of atmospheric pressure. Vacuum trenches in accordance with Paschen's law offer a high voltage blocking capability. That is, a vacuum trench may withstand high voltages between different locations along the trench.

According to another example, the cavity 21 is filled with a gas such, for example, a not ionizable gas. The pressure in the cavity 21 may correspond to atmospheric pressure in this example. However, it is also possible that the pressure in the cavity 21 is higher or lower than atmospheric pressure.

According to another example illustrated in Figure 7, the trench is entirely filled with a dielectric 24 between the trench bottom 2₃ and the source contact 4. According to one example, the dielectric 24 is a solid such as an oxide, a nitride, or the like, for example. Optionally, a void 25 is included in the dielectric 23, wherein the void 25 may help to avoid or reduce mechanical stress in the semiconductor body 100. Mechanical stress may result from different thermal expansion coefficients of the semiconductor material of the semiconductor body 100 and the dielectric. The void 25 may be filled with a gas. The pressure 25 in the void 25 may correspond to.

Referring to the above, the trenches may extend through the first semiconductor layer 110 into the second semiconductor layer 120. This, however, is only an example.

According to another example illustrated in Figure 8, the trenches 2 may extend into the first semiconductor layer 110 and terminate in the first semiconductor layer 110, so that trench bottoms 2₃ are spaced apart from the second semiconductor layer 120. According to one example, a distance, in the vertical direction z, between the trench bottoms 2₃ and the second semiconductor layer 120 is between 100 nanometers and 2 micrometers, for example. According to another example, the trench depth d is between 50% and 90% of the thickness (the dimension in the vertical direction) of the first semiconductor layer 110. In Figure 8, only the outline of one trench 2 is illustrated. The trench 2 may be implemented in accordance with any one of the examples according to Figures 6 and 7.

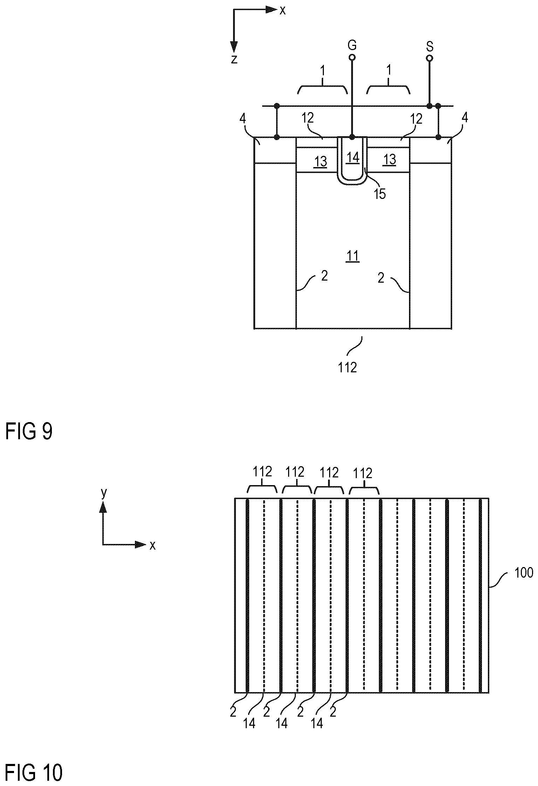

Different examples of the at least one transistor cell 1 that is at least partially integrated in each mesa region 112 of the semiconductor body 100 are explained below with reference to Figures 9 and 13 - 18. Each of Figures 9 and 13 - 18 illustrates a vertical cross sectional view of a section of the semiconductor body 100, wherein the illustrated section includes one section of a mesa region 112 and two trenches 2 adjoining the mesa region 112 in the first lateral direction x. The second semiconductor layer 120 is not illustrated in Figures 9 and 13 - 18.

Throughout the transistor device, the transistor cells 1 may be implemented in the same way. That is, each of the transistor cells 1 may be implemented in accordance with only one of the examples illustrated in Figures 9 and 13 - 18. This, however, is only an example. It is also possible, to implement one transistor device with different transistor cells.

Referring to Figures 9 and 13 - 18, each transistor cell 1 includes a source region 12, a body region 13 adjoining the source region 12, and a drift region 11. The drift region 11 is arranged between the body region 13 and the drain region 31 and may either adjoin the drain region 31 (when the optional buffer region 32 is omitted), or the buffer region 32. Furthermore, each transistor cell 1 includes a gate electrode 14 that is arranged adjacent to the body region 13 and is dielectrically insulated from the body region 13 by a gate dielectric 15. The gate electrode 14 is connected to a gate node G, which is only schematically illustrated in the figures. The gate electrode 14 (in a conventional way) serves to control a conducting channel in the body region 13 along the gate dielectric 15. The channel is controlled by a voltage (gate-source voltage) applied between the gate node G and the source node S when the transistor device is in operation. The gate electrode 14 may include a metal or doped polysilicon, for example.

Dependent on the shape of the trenches 2, the gate electrodes 14 may be implemented in various ways. Different examples are explained with reference to Figures 10 - 12 in the following. Each of these figures schematically illustrates a top view of one section of the semiconductor body 100 and schematically illustrates the form (shape) of the trenches 2 and the gate electrode(s) 14. The trenches 2 are represented by bold lines or dots and the gate electrodes 14 are represented by dashed lines in Figures 10 - 12. Other parts of the transistor device are not illustrated in Figures 10 - 12.

In the example illustrated in Figure 10, the trenches 2 are elongated trenches. In this example, the gate electrodes 14 are elongated electrodes that run essentially parallel to the trenches 2.

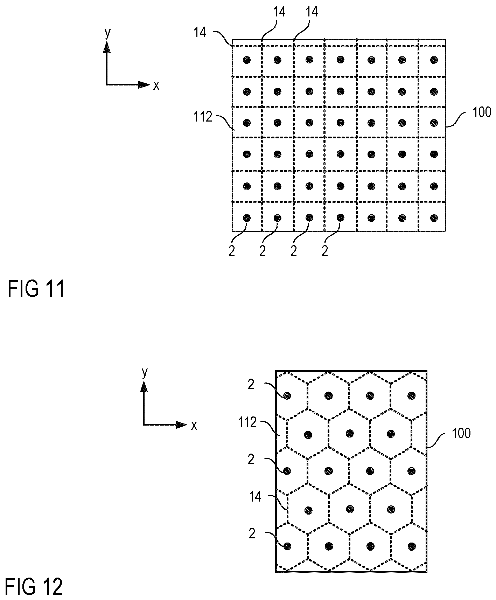

In the examples illustrated in Figures 11 - 12, the trenches 2 are needle trenches. In these examples, the gate electrodes 14 form a grid. The grid may have the shape of a rectangular grid, as illustrated in Figure 11, or a hexagonal grid, as illustrated in Figure 12, for example.

The transistor cells 1 of the transistor device are connected in parallel. This is achieved by connecting the gate electrodes 14 of the plurality of transistor cells 1 to the gate node G and by connecting the source and body regions 12, 13 of the plurality of transistor cells 1 to the source node S. Furthermore, each of the transistor cells 11 has its drift region 11 connected to the drain region 31, wherein the drain region 31 is connected to the drain node D.

The source and body regions 12, 13 of each transistor cell 1 are connected to the source node via a respective one of the source contacts 4. For this, the source and body regions 12, 13 are each connected to the respective source contact 4 located in the trench 2. Connections between the source contacts 4 and the source node S, and connections between the gate electrodes 14 and the gate node G are only schematically illustrated in Figures 9 and 13 - 19. These connections may be implemented in a conventional way using any kind of metallization layers and/or polysilicon layers.

According to one example, the drift region 11, the source region 12, the drain region 31, and the optional buffer region 32 are doped regions of a first doping type (conductivity type), and the body region 13 is a doped region of a second doping type (conductivity type) complementary to the first doping type. The transistor device can be implemented as an n-type device or as a p-type device. In an n-type device, the first doping type is an n-type and the second doping is a p-type. In a p-type device, the first doping type is a p-type and the second doping type is an n-type. Aluminum (Al) or boron (B) atoms may be used as p-type dopant atoms, and nitrogen (N) or phosphorous (P) atoms may be used as n-type dopant atoms, for example.

Furthermore, the transistor device with the plurality of transistor cells can be implemented as an enhancement device (normally-off device) or as a depletion device (normally-on device). In an enhancement device, the body region 13 adjoins the gate dielectric 15, as illustrated in the Figures 9 and 13 - 19. A depletion device, in addition to the body region 13, includes a channel region of the first doping type (the same doping type as the source region 12 and the drift region 11). The channel region is arranged between the gate dielectric 15 and the body region 13 and extends from the source region 12 to the drift region 11. Such channel region, however, is not illustrated in Figures 9 and 13 - 19.

According to one example, the doping concentration of the source region 12 is selected from between 1E18 cm⁻³ and 5E20 cm⁻³; the doping concentration of the body region 13, for an enhancement device , is selected from between 1E17 cm⁻³ and 1E18 cm⁻³ and, for a depletion device, is selected from between 1E10 cm⁻³ and 1E16 cm⁻³; and the doping concentration of the drift region 11 is selected from between 1E15 cm⁻³ and 8E17 cm⁻³.

The transistor device can be operated in a forward biased mode or a reverse biased mode. In the forward biased mode, a voltage is applied between the drain node D and the source node S such that a pn-junction formed between the drift region 11 and the body region 13 is reverse biased. An n-type transistor device, for example, is operated in the forward biased mode, when a positive voltage is applied between the drain node D and the source node S. In this operating mode, the transistor device conducts dependent on the gate-source voltage, wherein the transistor device conducts when the gate source-voltage is such that a conducting channel is generated along the gate dielectric 15 between the source region 12 and the drift region 11. Equivalently, the transistor device blocks, when the voltage applied between the drain node D and the source node S forward biases the transistor device and the conducting channel along the gate dielectric 15 is interrupted.

In the reverse biased mode, a polarity of the voltage between the drain node D and the source node S is such that the pn-junction formed between the body region 13 and the drift region 11 is forward biased. In this operating mode, the transistor device conducts independent of the gate-source voltage. Furthermore, in the reverse biased mode, the transistor device is in a bipolar mode, which is an operating mode in which electrons and holes occur in the drift region 11. In this operating mode, the body region 13 injects one of electrons and holes into the drift region 11, and the drain region 31 injects the other ones of electrons and holes into the drift region 11.

In the forward biased mode, when the transistor device is in an off-state, that is, when the conducting channel along the gate dielectric 15 is interrupted, a space charge region (depletion region) expands in the drift region 11 beginning at the pn-junction between the drift region 11 and the body region 13. The higher the voltage that is applied between the drain node D and the source node S, the farther this depletion region expands towards the drain region 31.

According to one example, the trenches 2 shown in Figures 9 and 13 - 19 are first trenches and the source regions 12 and body regions 13 are elongated regions that run parallel to the trenches 2. The source and body regions 12, 13 may be interrupted by optional second trenches crossing the first trenches. In the latter case, the source regions 12 (a) may be implemented as elongated regions that extend along the first trenches and are interrupted by the second trenches, wherein source contacts may be omitted in the second trenches and replaced by insulating plugs, or (b) may be implemented as ring-shaped regions (in the horizontal plane) that each have first sections extending along first trenches and second sections extending along second trenches.

In the example shown in Figure 9, two transistor cells 1 are integrated in one mesa region 112. In this example, the drift regions 11 of the transistor cells 1 are formed by one contiguous semiconductor region. The drift region 11 adjoins the body region 13, so that the pn-junction that is available between the drift region 11 and the body region 13 is directly formed between the body region 13 and the drift region 11. According to one example, the drift region 11 is a semiconductor region having the basic doping concentration of the mesa region 112. Furthermore, in the example shown in Figure 9, the gate electrodes 14 of the two transistor cells 1 are formed by one electrode, and the gate dielectrics 15 of the two transistor cells 1 are formed by one dielectric layer adjoining the common gate electrode 14.

In the example shown in Figure 9, the gate dielectric 14 is arranged in a trench that extends from the first surface 101 into the semiconductor body 100. This, however, is only an example. According to another example (not shown) the gate electrode 14 is implemented as a planar gate electrode that is arranged on top of the first surface 101. In this example, the drift region 11 includes a drift region sections that extends to the first surface 101. Transistor cells with a planar gate electrode are commonly known, so that no further explanation is required in this regard.

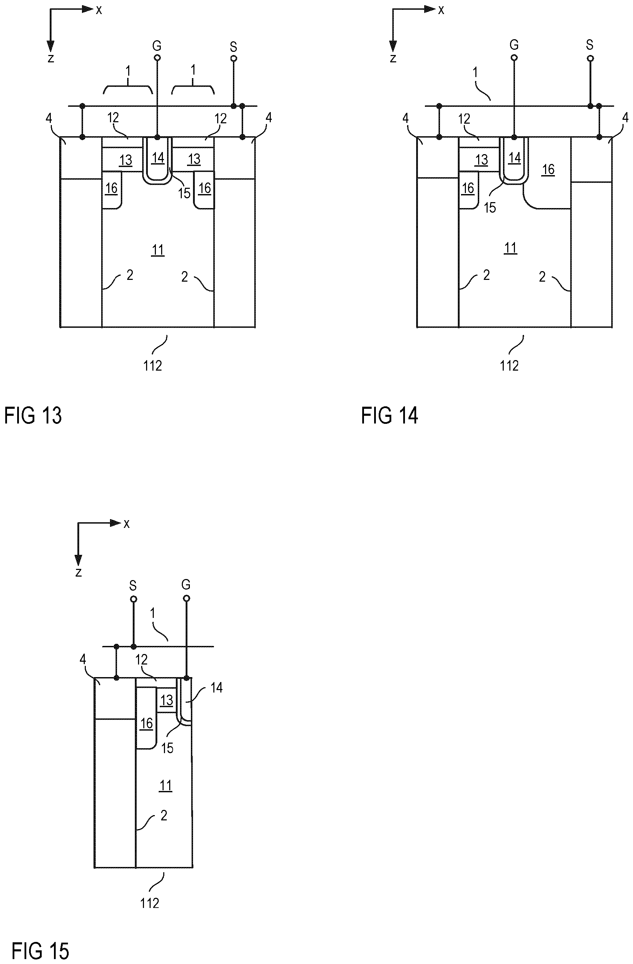

Figure 13 illustrates a modification of the transistor device according to Figure 9. In order to protect the gate dielectric 15 against high dielectric fields, the transistor device according to Figure 13 includes semiconductor regions 16 of a doping type complementary to the doping type of the drift region 11, wherein these semiconductor regions 16 adjoin the source contacts 4. These semiconductor regions 16 are spaced apart from each other in the first lateral direction x and form a JFET (junction field-effect transistor), wherein a section of the drift region 11 is arranged between the two semiconductor regions 16. The semiconductor regions 16 are also referred to as JFET regions in the following. A doping concentration of the JFET regions is selected from between 1E18 cm⁻³ and 1E20 cm⁻³, for example.

Referring to the above, in the forward biased mode, when the transistor device is in an off-state, that is, when the conducting channel along the gate dielectric 15 is interrupted, a space charge region (depletion region) expands in the drift region 11 beginning at the pn-junction between the drift region 11 and the body region 13. The higher the voltage that is applied between the drain node D and the source node S, the farther this depletion region expands towards the drain region 31. The expanding depletion region is associated with an electric field.

In the transistor device according to Figure 13, the depletion region also expands beginning at pn-junctions between the JFET regions 16 and the drift region 11. A doping concentration of the JFET regions 16 and the distance between the JFET regions 16 in the first lateral direction x are adapted to one another such that the drift region section arranged between the JFET regions 16 is completely depleted when the drain-source voltage reaches a predefined voltage level. The predefined voltage level is lower than a voltage level that may create electric fields that are suitable to damage the gate dielectric 15. In this way, the JFET regions 16 protect the gate dielectric 15 against high electric fields.

Figure 14 illustrates a modification of the example shown in Figure 13. In the example shown in Figure 14, only one transistor cell is integrated in the mesa region 112. For this, the body region 13 and the source region 12 adjoin only one sidewall of the gate trench. The "gate trench" is the trench in which the gate electrode 14 and the gate dielectric 15 are located. In this example, one of the JFET regions 16 may adjoin the gate trench on the side that is opposite to the side where the source region 12 and the body region 13 are arranged. Both JFET regions 16 adjoin a respective source contact 4.

In the examples illustrated herein, the gate trenches are drawn to have vertical sidewalls. This, however, is only an example. According to another example (not illustrated) sidewalls of the gate trenches are beveled. In this example, the opposite sidewalls of the gate trench may correspond to different crystal planes of the SiC semiconductor body. In a SiC semiconductor body, there are crystal planes in which charge carriers, such as electrons in an n-type device, have a higher mobility than in other crystal planes. This higher charge carrier mobility may result in a lower channel resistance when the channel region that is formed along the gate dielectric 15 is located in such crystal plane offering a higher charge carrier mobility. Such crystal planes include a-planes or m-planes, for example. According to one example, in a transistor device of the type shown in Figure 14, an interface between the body region 13 and the gate dielectric 15 is in a crystal plane offering a high carrier mobility, such as an a-plane or m-plane.

In the examples shown in Figures 13 and 14, each of the body and JFET regions 13, 16 adjoins a respective source contact 4. This, however, is only an example. According to another example illustrated in Figure 15, the body region 13 is connected to the source contact 4 via the JFET region, so that the JFET region 16 is located between the body region 15 and the source contact 4. The source region 4, in the first lateral direction x, extends along the JFET region 16 and extends to the trench 2 with the source contact 4.

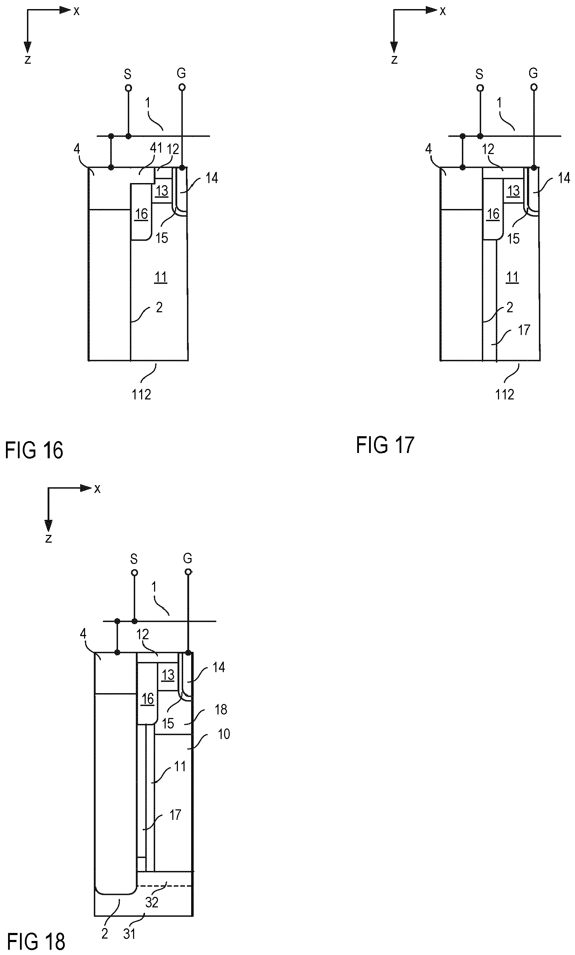

Figure 16 illustrates a modification of the examples shown in Figures 13 and 14. In the example shown in Figure 16, the source contact 4 includes a lateral extension 41 which, in the first lateral direction x, extends beyond the remainder of the source contact 4 and extends along the JFET region 16 to the source region 12. Optionally, the lateral extension 41 also adjoins a section of the body region 13.

Figure 17 illustrates one example of a transistor cell 1 of a superjunction transistor device. A transistor cell of the type shown in Figure 17 is referred to as superjunction transistor cell in the following. The superjunction transistor cell 1 includes a compensation region 17 that is connected to the source node S and adjoins the drift region 11. The transistor cell according to Figure 17 is based on the transistor cell according to Figure 15 and includes a JFET region 16 that adjoins the source contact 4. The compensation region 17 adjoins the JFET region 16, so that the compensation region 17 is connected to the source contact 4 and the source node S via the JFET region 16.

According to one example, a doping concentration of the compensation regions 17 is selected from between 5E16 cm⁻³ and 5E18 cm⁻³.

According to one example, a dimension of the compensation regions 17 in the vertical direction z, is at least 50%, at least 70%, or at least 90% of the thickness of the first semiconductor layer 110. The compensation region 17 may be implemented such it is spaced apart from the drain region 31 or the optional buffer region 32 in the vertical direction z, or such that it adjoins the drain region 31 or the optional buffer region 32. The compensation region 17 may adjoin the trench 2 (as illustrated) or may be spaced apart from the trench 2 in the first lateral direction x (not illustrated).

In the examples illustrated in Figures 9 and 13 - 17, the drift region 11 of each transistor cell 1 is formed by a doped region that has the basic doping concentration of the first semiconductor layer 110 and, therefore, the basic doping concentration of the mesa region 112. The source, body, JFET and compensation regions 12, 13, 16, 17 may be formed by implantation processes explained herein further below.

Figure 18 shows a modification of the transistor cell according to Figure 17. In the example according to Figure 18, the drift region 11 is an implanted region that extends along the compensation region 17 from the JFET region 16 to the buffer region 32 or the drain region 31 (when the buffer region 31 is omitted). The compensation region 17 may extend to the buffer region 32 or drain region 31 (not illustrated), or may be spaced apart from the buffer region 32 or drain region 31 (as illustrated). In the first lateral direction x, the drift region 11 is arranged between the compensation region 17 and a region 10, wherein the region 10 has a doping concentration that corresponds to the basic doping concentration of the first semiconductor layer 110 and the mesa region 112.

In the example shown in Figure 18, the drift region 11 is spaced apart from the body region 13 and the gate dielectric 15. Thus, the drift region 11 is spaced apart from a channel region extending in the body region 13 along the gate dielectric 15. In order to connect the drift region 11 to the channel region, the transistor cell 1 further includes a doped region 18 of the first doping type, which is referred to as current spreading region in the following. The current spreading region 18 extends from the gate dielectric 15 to the drift region 11, so that in the on-state a current can flow from the source region 12 along the gate dielectric 15 in the body region 13 and the current spreading region 19 to the drift region 11, and via the drift region 11 to the drain region 32. In this example, the pn-junction between the body region 13 and the drift region 11 is formed between the body region 13 and the current spreading region 18. A doping concentration of the current spreading region 18 is higher than a doping concentration of the drift region 18, for example. According to one example, the doping concentration of the current spreading region 18 is selected from between 2 times and 100 times, in particular, from, between 2 times and 20 times the doping concentration of the drift region. In absolute values, the doping concentration of the current spreading region 18 is selected from between 1E16 cm⁻³ and 5E17 cm⁻³.

Various examples of methods for forming source and body regions 12, 13, JFET regions 16, and drift and compensation regions 11, 17 of transistor cells 1 are explained in the following.

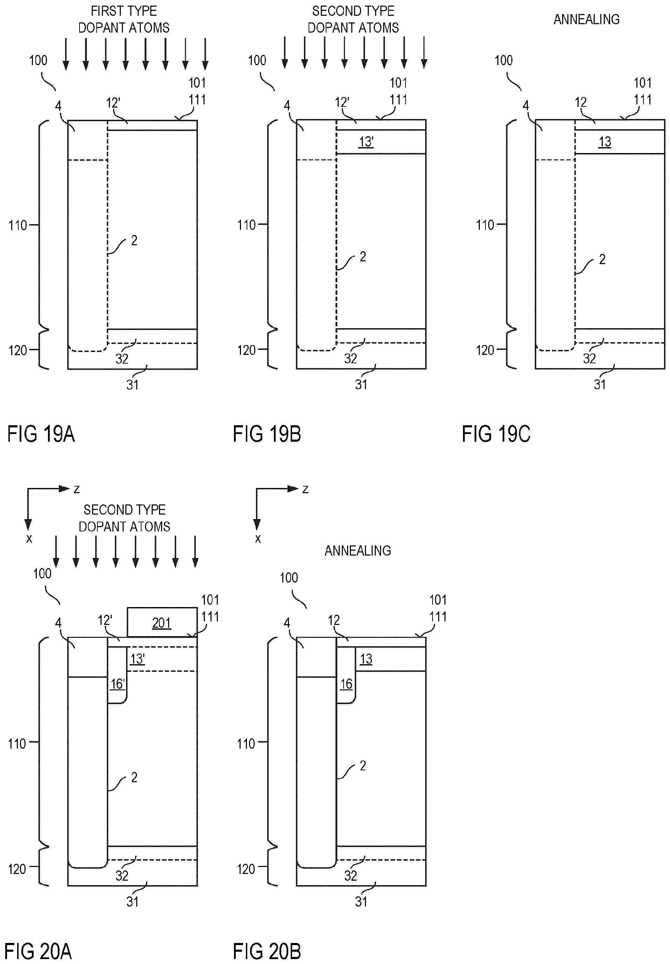

Figures 19A - 19C illustrate one example of a method for forming source and body regions 12, 13. The source and body regions 12, 13 can be formed before forming the trenches 2 with the source contacts 4 or after forming the trenches 2 with the source contacts 4. A trench 2 and a corresponding source contact 4 is illustrated in dashed lines in Figures 19A - 19C. Each of Figures 19A - 19C shows a vertical cross sectional view of one section of the semiconductor body 100 during the method of forming the source and body regions 13.

Referring to Figure 19A, the method includes implanting first type dopant atoms via the first surface 101 into the semiconductor body 100 to form a first implanted region 12' that includes dopant atoms of the first doping type. The position and the size of the first implanted region 12' in the semiconductor body 100 essentially corresponds to the desired size and position of the source region 12.

Referring to Figure 19B, the method further includes implanting second type dopant atoms via the first surface 101 into the semiconductor body 100 in order to form a second implanted region 13' that includes dopant atoms of the second doping type. A position and size of the second implanted region 13' essentially corresponds to a desired size and position of the body region 13.

Referring to Figure 19C, the method further includes an annealing process in order to activate the implanted first type dopant atoms and second type dopant atoms, so as to form the source region 12 based on the first implanted region 12' and the body region 13 based on the second implanted region 13'. Doping concentrations of the source and body regions 12, 13 are adjusted by suitably adjusting implantation doses in the implantation processes illustrated in Figures 19A and 19B. According to one example, the annealing process takes place at temperatures of between 1500°C and 1800°C. The duration is between 5 minutes and 120 minutes, for example.

Forming each of the first and second implanted regions 12', 13' may include only one respective implantation process. This, however, is only an example. According to another example, two or more implantation processes may be used to form each of the first and second implanted regions 12", 13', wherein the two or more implantation processes used for forming one of the first and second implanted regions 12', 13' may be different with regard to the implantation energy and the implantation dose.

Although the first implanted region 12' is formed before the second implanted region 13' in the example illustrated in Figure 19A - 15C, this is only an example. It is also possible to form the second implanted region 13' before the first implanted region 12'.

Referring to Figure 19C, forming the source and body regions 12, 13 includes an annealing process. In the example shown in Figures 19A - 19C, the annealing process is illustrated right after forming the first and second implanted regions 12', 13'. This, however, is only an example. The annealing process may take place any time after forming the first and second implanted region 12', 13'. This includes that the annealing process takes place after forming the first and second implanted regions 12', 13' and further implanted regions, such as implanted regions for forming JFET regions 16, compensation regions 17, or drift regions 11.

Figures 20A - 20B illustrate one example of a method for forming a JFET region 16. The method according to Figures 20A - 20B includes forming the JFET region 16 after forming the trench 2 with the source contact 4. Referring to Figure 20A, the method includes implanting second type dopant atoms via the first surface 101 into the semiconductor body 100 in order to form a third implanted region 16'. A position and size of the third implanted region 16' essentially corresponds to a desired size and position of the JFET region 16. Forming the third implanted region 16' includes forming an implantation mask 201 on top of the first surface 101, wherein the implantation mask 201 leaves those regions of the first surface 101 uncovered into which the second type dopant atoms are to be implanted in order to form the third implanted region 16'. Referring to Figure 20A, the third implanted region 16' is formed such that it adjoins the trench 2 and the source contact 4.

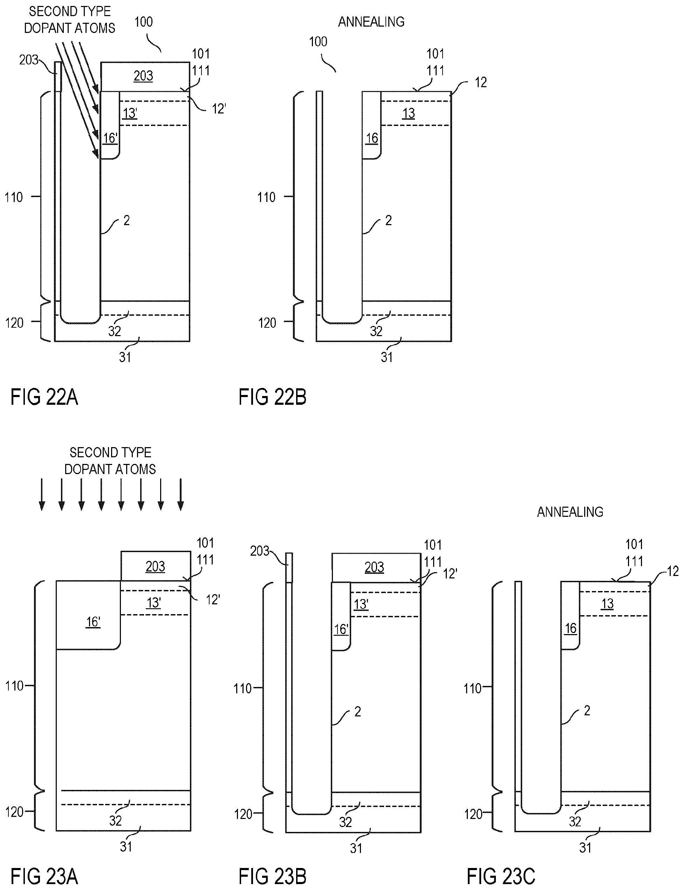

The first and second implanted regions 12', 13' are illustrated in dashed lines in Figure 22A. These regions may be formed before or after forming the third implanted region 16'.

Referring to Figure 20A, the implantation energy in the implantation process for forming the third implanted region 16' is selected such that, in the vertical direction z and as seen from the first surface 101, the third implanted region 16' is below the first implanted region 12'. Thus, forming the third implanted region 16' and forming the JFET region 16 based on the third implanted region 16' does not affect forming the source region 12, so that the source region 12, in the first lateral direction x and along the JFET region 16, extends to the source contact 4 in the trench 2.

Forming the JFET region 16 based on the third implanted region 16' includes an annealing process. Figure 20B shows the source and body regions 12, 13 and the JFET region 16 after the annealing process and after removing the implantation mask 201.

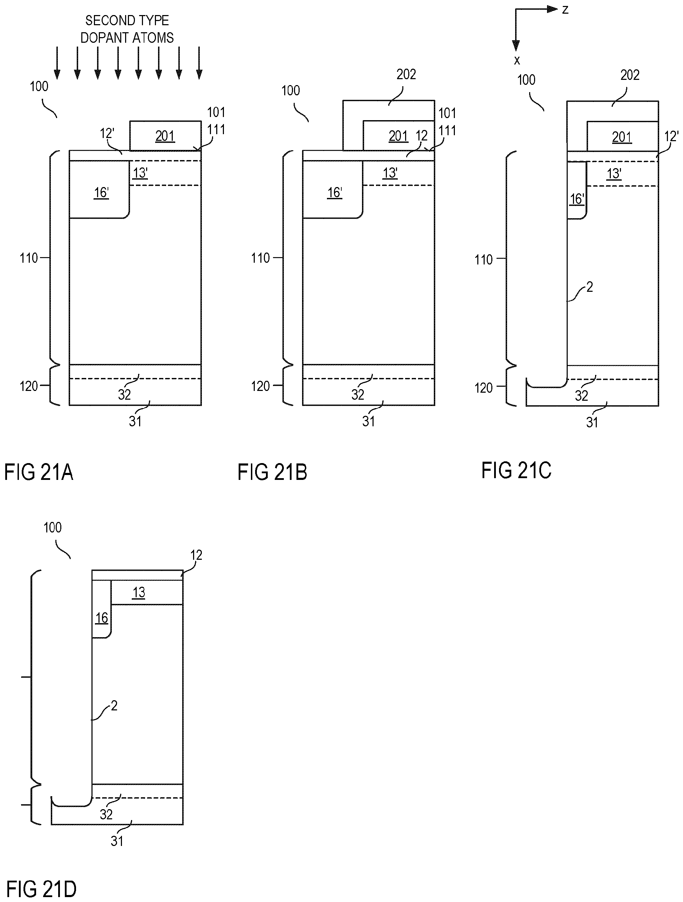

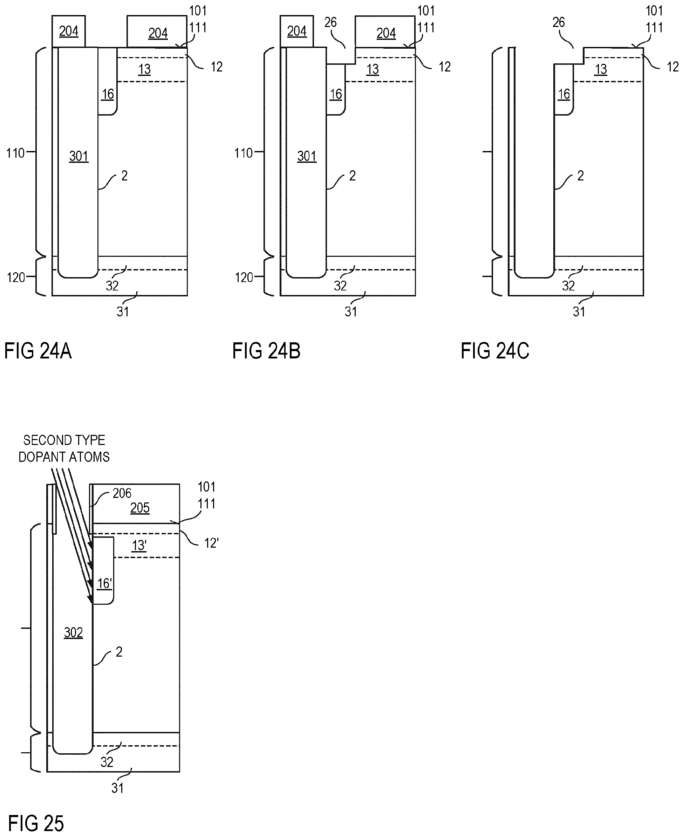

Figures 21A - 21D illustrate a modification of the method according to Figures 20A - 20B. Referring to Figure 25A, the method includes forming the third implanted region 16' by implanting second type dopant atoms via the first surface 101 into the semiconductor body 100 before forming the trench 2. Implanting the second type dopant atoms includes forming an implantation mask 201 on top of the first surface 101, wherein the implantation mask 201 leaves those sections of the first surface 101 uncovered into which the second type dopant atoms are to be implanted.

Referring to Figures 21B - 21C, the method further includes forming the trench 2. Forming the trench 2 includes forming an etch mask 202, wherein the etch mask 202 leaves those sections of the first surface 101 uncovered where the trench 2 is to be etched. According to one example, the etch mask 202 is formed such that it covers the implantation mask 201 and covers a section of the first surface 101 adjoining the implantation mask 201 in the first lateral direction x, so as to form a spacer. A dimension of the spacer in the first lateral direction x defines a dimension of the JFET region 16 after forming the trench 2.

Forming the JFET region 16 based on the third implanted region 16' includes an annealing process. This annealing process may be the same annealing process that forms the source and body regions 12, 14 based on the first and second implanted regions 12', 13'. These first and second implanted regions 12', 13' may be formed before forming the third implanted region 16' or may be formed after forming the trench and removing the etch mask 22 and the implantation mask 201. The first and second implanted regions 12', 13' and the source and body regions 13, 14 are illustrated in dashed lines in Figures 21A - 21C.

The annealing process 4 for activating the implanted dopant atoms may take place before or after etching the trench. Just for the purpose of illustration it is assumed that the annealing process takes place after forming the trench 2, so that Figure 21C shows the first, second, and third implanted regions 12', 13', 16' (instead of the source, body and JFET regions 12, 13, 16). Figure 20D shows the semiconductor body 100 after the annealing process with the trench 2 and the source, body and JFET regions 12, 13, 16.

In the method according to Figures 21A - 21D, the third implanted region 16' is formed such that, in the vertical direction z, it is arranged below the first implanted region 12'. Thus, after the annealing process, the source region 12 extends along the JFET region 16 to the trench 2, in which the source contact 4 is to be formed.

Figures 22A - 22B illustrate another example of a method for forming the third implanted region 16'. Referring to Figure 22A, this method includes implanting second type dopant atoms via a sidewall of the trench 2 into the mesa region 112. An implantation mask 203 covers the first surface 101 in order to prevent second type dopant atoms from being implanted into the first surface 101. The first and second implanted regions 12', 13', which are illustrated in dashed lines in Figure 24A, may be formed before or after forming the third implanting region 16'.

In the event that the trenches 2 are elongated trenches, forming the implanted regions 16' may include two implantation processes, a first process for forming implanted regions 16' along first sidewalls of the trenches 2, and a second process for forming implanted regions 16' along opposite second sidewalls of the trenches 2. In the event that the trenches are needle trenches more than two implantations in different directions may be used in order to form the implanted region 16' such that the implanted region 16' surrounds the needle trench 2.

Figure 22B shows the arrangement according to Figure 22A after forming the first and second implanted regions and an annealing process to form the source, body and JFET regions 12, 13, 16. Figure 22B shows the arrangement before forming the source contact 4. It should be noted that in the example according to Figures 22A-22B, as well as ion the other examples explained herein, the annealing process may take place after forming the source contact 4.

Figures 23A - 23C illustrate a modification of the method according to Figures 21A - 21C. The method according to Figures 23A - 23C is different from the method according to Figures 21A - 21C in that the third implanted region 16' is formed such that it essentially extends to first surface 101. Thus, the JFET region 16 (see Figure 23C), in the first lateral direction x, is arranged between the source region 12 and the trench 2. The same applies to the arrangement according to Figure 22B, in which the JFET region 16 has been formed based on a third implanted region 16' that, in the vertical direction z, extends to the first surface 101.

Figures 24A - 24C illustrate one example of a method for forming a lateral trench extension 26. The lateral trench extension 26 is formed such that - after forming the source, body, and JFET regions - it extends in the first lateral direction x through the JFET region 16 to the source region 12. The lateral trench extension helps to form a source contact 4 of the type shown in Figure 16, which laterally extends beyond the JFET region 16 to the source region 12.

Referring to Figure 24A, the method includes filling the trench with a sacrificial material 301 and forming an etch mask 204 on top of the first surface 101. The etch mask 204 does not cover the JFET region 16 and defines the dimension in the first lateral direction x of the lateral extension 41 of the source contact 4 in the final transistor device.

Referring to Figure 24B, the method further includes etching a cavity 26 in the first surface 101 of the semiconductor body 100 in a region adjoining the sacrificial material 301.

Figure 24C illustrates the arrangement according to Figure 24B after removing the etch mask 204 and removing the sacrificial material 301 from the trench 2.

Figure 25 illustrates another example of a method for forming the third implanted region 16' such that it is arranged below the first implanted region 12'. It should be noted that the first implanted region 12' may be formed before or after forming the third implanted region 16'. The first implanted region 12' as well as the second implanted region 13' is illustrated in dashed lines in Figure 25.

Referring to Figure 25, the method includes implanting second type dopant atoms via one of the sidewalls of the trench 2 into the mesa region 112, wherein a protection layer 206 covers those sections of the sidewall into which the second type dopant atoms are not to be implanted and where, in the finished transistor device, the source region 12 adjoins the trench sidewall in order to be contacted by the source contact 4.

Everything explained above in view of Figure 22A with regard to the number of implantation processes for forming the implanted region 16' applies to the method according to Figure 25 accordingly.

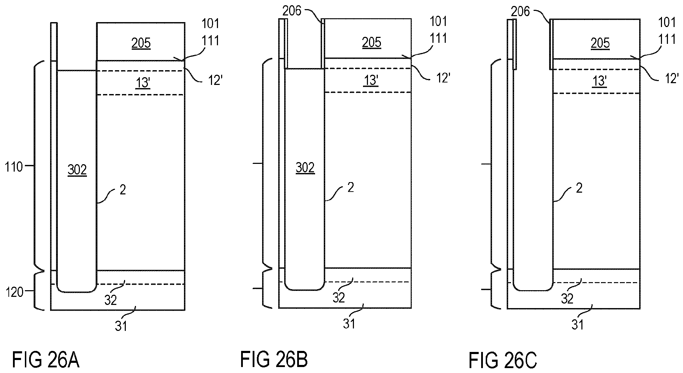

Figures 26A - 26D illustrate one example of a method for forming the protection layer 206. Referring to Figure 26A, the method includes forming an implantation mask 205 that covers the first surface 101 of the semiconductor body 100, and partially filling the trench 2 with a sacrificial material 302. Partially filling the trench 2 with the sacrificial material 302 includes filling the trench 2 such that the sacrificial layer 302 does not cover those sections of the sidewall on which the protection layer 206 is to be produced and which are to be protected from having dopant atoms implanted therein.

According to one example, the implantation mask is the same mask (etch mask) that is used for etching the trench 2 into the semiconductor body 100. That is, the method may include forming an etch mask 101 on top of the first surface 101, etching the trench 2 using the etch mask, and leaving the etch mask in place as the implantation mask 205. Partially filling the trench 2 with the sacrificial material may include completely filling the trench 2 with the sacrificial material 302 and etching back the sacrificial material down to the desired vertical position.

Figure 26B shows the arrangement after forming the protection layer 206. Forming the protection layer 206 may include depositing a protection layer on top of the entire arrangement and performing an anisotropic etching process that removes the protection layer from horizontal surfaces and leaves the protection layer on vertical surfaces, such as sidewall sections of the trench and vertical sidewalls of the implantation mask 205.

Figure 26C shows the arrangement after forming the protection layer 206 and removing the sacrificial material 302 from the trench 2.

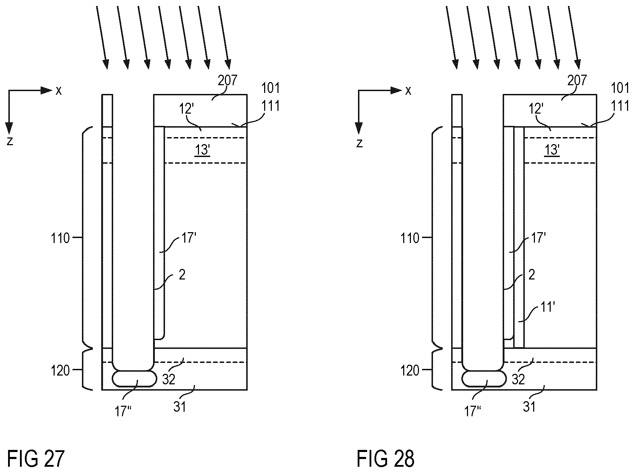

Referring to Figures 17 and 18, the transistor cells 1 may be implemented as superjunction transistor cells, wherein each of these transistor cells 1 includes at least one compensation region 17 of the second doping type. Figure 27 illustrates one example of a method for forming a compensation region 17 along a trench sidewall of a trench 2. According to this example, forming the compensation region 17 includes implanting second type dopant atoms via the trench sidewall into the mesa regions 112 before closing the trench 2, that is, before forming the source contact 4. Figure 27 shows a vertical cross sectional view of one section of the semiconductor body 100 at different stages of the process.

Referring to Figure 27, the method includes at least one first implantation process in which second type dopant atoms are implanted via the trench sidewall into the mesa region 112 to form a fourth implanted regions 17' in the mesa regions 112 along the trench sidewall. A size and position of the fourth implanted region essentially equals a desired size and position of the compensation region 17, wherein the compensation region 17 is formed from the fourth implanted region 17' in an annealing process.

The fourth implanted region 17' may be formed before or after forming the first and second implanted regions 12', 13', which are illustrated in dashed lines in Figure 27, and may be formed before or after forming the optional third implanted region 16' (which is not illustrated in Figure 27). The annealing process may be the same annealing process that forms the source and body regions 12, 13 based on the first and second implanted regions 12', 13' and/or that forms the optional JFET region 16 based on the third implanted region 16'.

Referring to Figure 27, an implantation mask 207 may be formed on top of the first surface 101 before the implantation process, for forming the fourth implanted region 17'. The implantation mask 202 is configured to prevent dopant atoms from being implanted into the first surface 101. According to one example, the implantation mask 207 is the same as the etch mask used in an etching process for forming the trenches 2.

Figure 27 illustrates implanting dopant atoms into a first one of two opposite sidewalls of the trench 2 in order to form the fourth implanted region 17' along the first sidewall. It goes without saying that the same type of process may be used to form a further fourth implanted region along the opposite sidewall.

Referring to Figure 27, the fourth implanted region 17', in the vertical direction z, extend from the first surface 101 towards the second semiconductor layer 110. A dimensions of the fourth implanted region 17' in the vertical direction z is dependent on an implantation angle used in the implantation process. The vertical dimension of the fourth implanted region 17' can be adjusted by suitably selecting the implantation angle dependent on the trench width w and the thickness of the implantation mask 207. The thickness of the implantation mask 207 is the dimension of the implantation mask 202 in the vertical direction z. Basically, at a given width of the trenches 2 and a given thickness of the implantation mask 207, the smaller the implantation angle relative to the vertical direction z, the deeper the fourth implanted region 17' extends in the vertical direction z inside the mesa regions 112. Referring to Figure 27, the implantation angle may be adjusted such that the fourth implanted region 17' is spaced apart from the second semiconductor layer 120 in the vertical direction z. This, however, is only an example. According to another example, the implantation angle is adjusted such that the fourth implanted region 17' extends into the second semiconductor layer 120. Furthermore, just for the purpose of illustration, in the example shown in Figure 27A, the trench 2 extends into the second semiconductor layer 120.

The implantation dose of the second type dopant atoms in the implantation process, dependent on the implantation angle, are adjusted such that the compensation region 17 (which is formed in the annealing process based on the fourth implanted region 17') has a desired doping concentration.

According to one example, forming the compensation 17 may include forming the compensation region 17 such that it includes different sections with different doping concentrations, so that that the compensation region 17 has a vertically varying doping concentration. This may be achieved by forming two or more subsections of the fourth implanted region, wherein each of these subsections extends from the first surface 101 in the vertical direction z, and wherein the different subsections have different vertical dimensions. Forming each of the subsections includes an implantation process, wherein implantation angles in the implantation processes are different, so as to achieve different vertical dimensions of the subsections.

In the implantation process according to Figure 27, some of the dopant atoms may be scattered at the trench sidewalls 2₁, 2₂, wherein some of the scattered dopant atoms may end up in the second semiconductor layer 120 below the bottom of the trench 2. In Figure 27, reference number 17" denotes an implanted region that results from scattered dopant atoms in the implantation process. In the annealing process a doped region results from the implanted region 17" formed by the scattered atoms. According to one example, the doping concentration of the first doping type of the second semiconductor layer 120 is significantly higher than a doping concentration of the doped region resulting from the scattered dopant atoms, so that the scattered dopant atoms of the second doping type do not negatively affect the functionality of the transistor device.

In the event that the trenches 2 are elongated trenches, forming the implanted regions 17' may include two implantation processes, a first process for forming implanted regions 17' along first sidewalls of the trenches 2, and a second process for forming implanted regions 17' along opposite second sidewalls of the trenches 2. In the event that the trenches are needle trenches more than two implantations in different directions may be used in order to form the implanted region 17' such that the implanted region 17' surrounds the needle trench 2.

As explained above, the drift regions 11 of the transistor cells 1 may be formed by sections of the first semiconductor layer 110 that have the basic doping of the first semiconductor layer 110. In this case, in order to form superjunction transistor cells, second type dopant atoms may implanted into the mesa regions 112 as a basis for forming the compensation regions 17. According to another example, illustrated in Figure 18, the drift regions 11 of the transistor cells are doped regions formed in the mesa region 112.

Forming drift regions 11 of this type, may include implanting dopant atoms of the first doping type via the trench sidewalls into the mesa region 112 to form fifth implanted regions 11', and an annealing process. The annealing process forms the drift regions 11 based on the fifth implanted regions 11'.

Figure 28 shows a vertical cross sectional view of one section of the semiconductor body 100 after forming a fifth implanted region 11' in addition to a fourth implanted region 17'. The same type of process used for forming the fourth implanted regions 17' may be used for forming fifth implanted regions 11'.

In the event that the trenches 2 are elongated trenches, forming the implanted regions 11' may include two implantation processes, a first process for forming implanted regions 11' along first sidewalls of the trenches 2, and a second process for forming implanted regions 11' along opposite second sidewalls of the trenches 2. In the event that the trenches are needle trenches more than two implantations in different directions may be used in order to form the implanted region 11' such that the implanted region 11' surrounds the needle trench 2.

Referring to Figures 27 and 28, the fourth implanted region 17 and the fifth implanted region 11' may extend to the first surface 101. According to one example, doping concentrations of the compensation regions 17 and drift regions 11 resulting from the fourth and fifth implanted regions, respectively, are much lower than doping concentrations of the source and body regions 12, 13, so that forming the compensation and drift regions 17, 11 as explained with reference to Figures 27 and 28 does not negatively affect connecting the source and body regions to the source contact 4 (not shown in Figures 27 and 28).

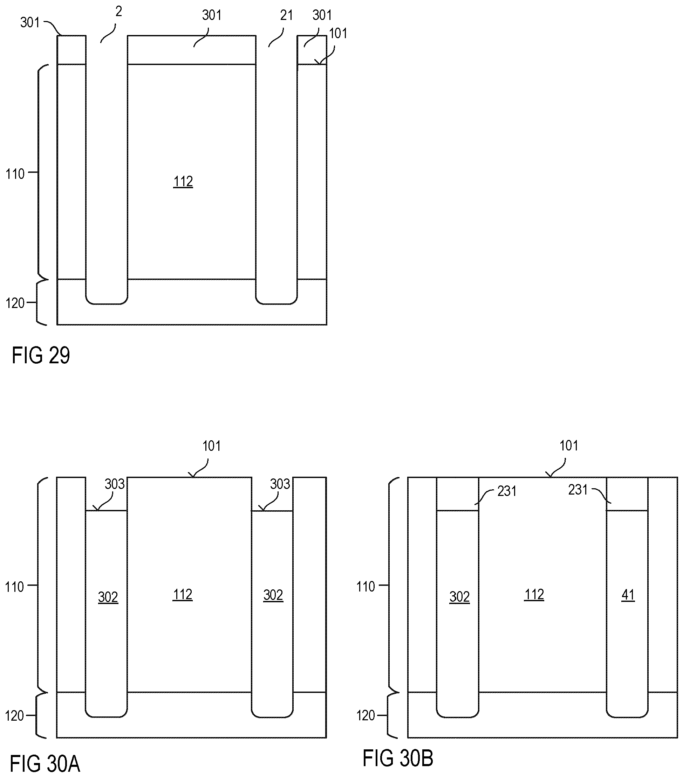

Figure 29 illustrates one example of a method for forming the trenches 2. It should be noted that Figure 29 only illustrates a section of the semiconductor with the first and second semiconductor layers 110, 120. Doped regions, such as source, body or JFET regions 12, 13, 26, which may be formed before forming the trenches 2, are not illustrated. Furthermore, just for the purpose of illustration it is assumed that forming the trenches 2 includes forming the trenches such that they extend into the second semiconductor layer 120. The method, however, is not restricted to this example but may also be used for forming trenches 2 that terminate in the first layer 110.

Forming the trenches 2 may include an etching process. According to one example illustrated in Figure 29, the etching process includes forming an etch mask 301 on top of the first surface 101. The etch mask 301 includes openings in which the first surface 101 of the semiconductor body 100 is not covered. The method further includes etching the semiconductor body 100 in those sections in which the etch mask 301 does not cover the first surface 101. According to one example, the etching process is an anisotropic etching process. A duration of the etching process is adjusted such that the etching process ends when a desired trench depth has been reached.

Figures 30A - 30H illustrate one example of a method for forming a trench structure of the type shown in Figure 6 that includes cavities 21 in trenches 2 and source plugs 4 arranged above the cavities 21. Each of Figures 30A - 30H illustrates one section of the semiconductor body 100 that includes two trenches. Furthermore, in the example shown in Figures 30A - 30H, the trenches 2 extend into the second semiconductor layer 120, which, however, is only an example.

Referring to Figure 30A, the method includes partially filling the trenches 2 with a sacrificial plug 302. According to one example, the sacrificial plug 302 includes a sacrificial material that can be etched selectively relative to the semiconductor body 100. According to one example, the sacrificial material includes polysilicon or an oxide. The oxide is silicon oxide (SiO₂), for example, and may be formed based on depositing TEOS (tetraethoxysilane). "Partially filling" the trenches 2 by the sacrificial plug 302, includes filling the trenches 2 such that the sacrificial plug 302 does not completely fill the trenches 2. That is, an upper surface 303 of the sacrificial plug 302 is spaced apart from the first surface 101 in the vertical direction z, wherein a distance between the surface 303 of the sacrificial material 302 and the first surface 101 of the semiconductor body 100 essentially defines a vertical dimension of the source plug 5 that is to be formed. This is explained in the following.

Referring to Figure 30B, the method further includes filling a gap (residual trench) between the sacrificial plug 302 and the first surface 101 with a first plug 231. The dielectric layer 23 between the cavity and the source contact 4 (which may also be referred to as source contact plug) is formed based on the first plug 231 according to Figure 30B. This is explained in detail herein further below. The first plug 231 includes an oxide, such as silicon oxide (SiO₂), for example.

Forming the first plugs 231 may include depositing a plug material layer such that the plug material layer fills the gaps (the residual trenches) on top of the sacrificial material 302 and covers the first surface 101 of the semiconductor body 100. Forming the plug material layer may include a deposition process. Forming the plugs 231 may further includes planarizing the plug material layer, so that the first surface 101 is uncovered and plug material remains in the trenches 2 on top the sacrificial material 302. The plug material remaining on top of the sacrificial material 302 forms the first plugs 231.

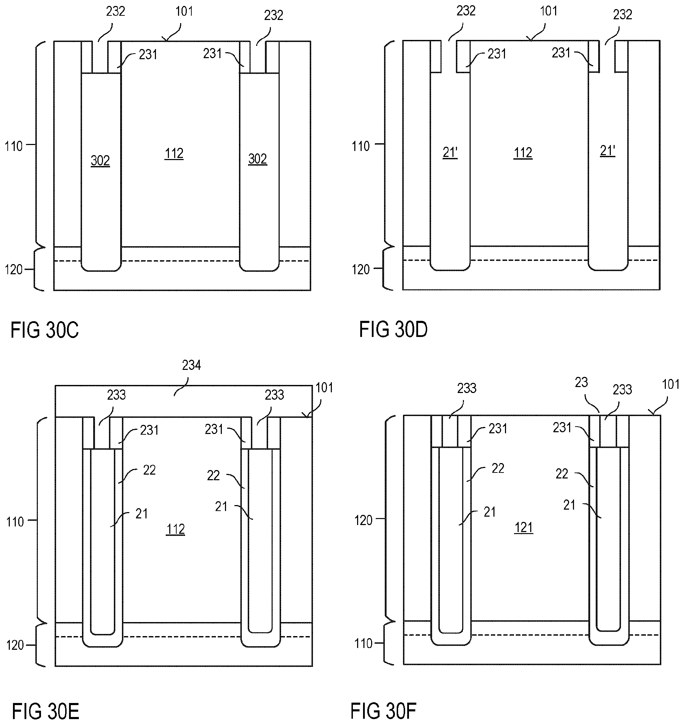

Referring to Figure 30C, the method further includes forming an opening 232 in each of the first plugs 231, wherein the opening 232 extends through the first plug 231 down to the sacrificial plug 302. Forming the opening 232 may include an etching process using an etch mask (not illustrated in Figure 30C).

Referring to Figure 30D, the method further includes removing the sacrificial material 302 via the openings 232 formed in the first plugs 231. Removing the sacrificial material 302 may include an isotropic etching process in which the sacrificial material 302 is removed selectively relative to the semiconductor body 100 and the first plugs 231, so that voids 21' are formed in the trenches 2 below the plugs 231. If, for example, the sacrificial plug 302 includes polysilicon TMAH (tetramethylammonium hydroxide) may be used to selectively remove the sacrificial plugs 302.

Referring to Figures 30E - 30H, the method further includes closing the openings 232 in the first plugs 231 and partially removing the first plugs 231 so as to form the dielectric layers 23 of the finished transistor device.

According to one example, closing the openings 232 of the plugs 231 takes place in a low pressure (vacuum) atmosphere, so that a pressure in the voids 21' after closing the voids 21' essentially equals the ambient pressure in the process of closing the plugs. This pressure may be significantly lower than atmospheric pressure. According to one example, closing the openings 232 in the plugs 231 includes a high density plasma process (HDP process) in which plug material 233, such as an oxide, is deposited. The duration of this process may be selected such that the openings 232 in the first plugs 231 are completely closed by the plug material 23.

Referring to Figure 30E, plug material may be deposited on each surface of the structure according to Figure 30D, so that plug material is also deposited on sidewalls and bottoms of the trenches 2 before the openings 232 are closed. The plug material deposited in the trenches 2 forms the optional dielectric layer 22 explained herein before. Due to the nature of the process, the dielectric layer 22 may be thicker at the bottom of each trench 2 than along the sidewalls.

According to one example, an oxide layer (not shown) is formed on the sidewalls and the bottom of the trenches 2 before initiating the process of closing the openings 232, such as an HDP process. Forming the oxide layer may include a thermal oxidation process. The oxide layer may help to reduce surface charges at the interface between the trenches 2 and the adjoining semiconductor material of the semiconductor body 100.

As illustrated in Figure 30E, the plug material may also be deposited on the first surface 101 of the semiconductor body 100. The plug material 234 deposited on the first surface 101 may be removed in a planarizing process, wherein the result of this process is illustrated in Figure 30F. The planarizing process includes a chemical and/or mechanical polishing process, for example.

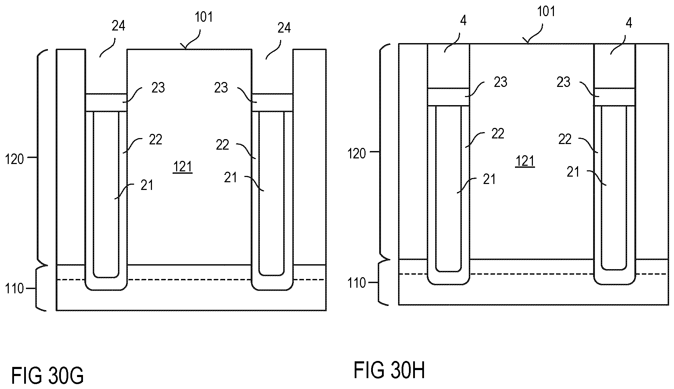

Referring to Figure 30G, the method further includes partially removing each plug 231 to form the dielectric layer 23 and a gap or trench 24 between the dielectric layer 23 and the first surface 101. According to one example, partially removing the plugs 231 includes a selective etching process in which the plugs 231 are etched selectively relative to the semiconductor material of the semiconductor body 100.

Referring to Figure 30H, the method further includes forming the source contacts 4 in the trenches 25 above the dielectric layers 23. Forming the source contacts 4 may include depositing an electrically conducting layer such that the trenches 25 are completely filled and the first surface 101 of the semiconductor body 100 is covered by the electrically conducting layer. Forming the source contacts 4 may further include removing the electrically conducting layer from the first surface 101 so that electrically conducting material remains in the trenches 25 to form the source contacts 4.

The electrically conducting layer that forms the source contacts 4 may include only one conducting material or may include a layer stack with two or more different conducting materials. Examples of the conducting material include metals such as nickel (Ni), titanium (Ti), aluminum (Al), or tungsten; nitrides such as titanium nitride TiN; or silicides such as titanium silicide (TiSi), aluminum silicide (AlSi).

Removing the electrically conducting layer from the first surface 101may include a planarizing process such as a chemical and/or mechanical polishing process, wherein the semiconductor body 100 may act as a stop layer.

The method according to Figures 30A - 30H may easily be modified to fill the trench 2 below the source contact 4 with a dielectric layer (as illustrated in Figure 7). In this case, dielectric plugs may be formed instead of the sacrificial plugs illustrated in Figure 30A, and the gaps above the dielectric plugs are filled with an electrically conductive material in order to form the source contacts.

Referring to the above, each of the transistor cells 1 includes a gate electrode 14 and gate dielectric 15, wherein the gate electrode 14 and the gate dielectric may be formed in a gate trench. Forming the gate electrode 14 and the gate dielectric 15 in a gate trench may include forming the gate trench, forming the gate dielectric 15 on sidewalls and the bottom of the gate trench, and filling a residual trench remaining after forming the gate dielectric 5 with a gate electrode material to form the gate electrode. This type pf process is commonly known. The gate electrodes 14 and the gate dielectrics 15 may be formed before forming the trenches 2 or after forming the trenches 2. According to one example, the gate electrodes 14 and the gate dielectrics 15 are formed after forming the trenches 2, the cavities 21 and the first plugs 231 closed with the plug material and before forming the source plugs 4.

## Claims

1. A transistor device, comprising:
a SiC semiconductor body (100) that includes a first semiconductor layer (110);
a plurality of trenches (2) each extending from a first surface (111) of the first semiconductor layer (110) into the first semiconductor layer (110); and
a plurality of transistor cells (1) each coupled to a source node (S),
wherein the first semiconductor layer (110) includes a plurality of mesa regions (112) each formed between two neighboring ones of the trenches (2),
wherein, in each of the mesa regions (112), at least one of the plurality of transistor cells (1) is at least partially integrated,
wherein each of the transistor cells (1) is connected to the source node (S) via a respective source contact (4),
wherein each of the source contacts (4) is arranged in a respective one of the trenches (2) and is spaced apart from a bottom (2₃) of the respective trench (2).

2. The transistor device of claim 1,
wherein at least some of the plurality of trenches (2) comprise a cavity (21) between the respective trench bottom (2₃) and the source contact (4).

3. The transistor device of any one of the preceding claims,
wherein the semiconductor body (100) further comprises a second semiconductor layer (120),
wherein at least a section of the second semiconductor layer (120) forms a drain region (31) of the transistor device, and
wherein the first semiconductor layer (110) is formed on top of the second semiconductor layer (120).

4. The transistor device of claim 3,
wherein the trenches (2) extend through the first semiconductor layer (110) into the second semiconductor layer (120).

5. The transistor device of any one of the preceding claims,
wherein each transistor cell (1) comprises:
a source region (12) connected to the source contact (4);
a body region (13) adjoining the source region (12);
a drift region (11); and
a gate electrode (15) arranged adjacent to the body region (13) and dielectrically insulated from the body region (13) by a gate dielectric (15).

6. The transistor device of any one of claims 4 to 5,
wherein each transistor cell (1) further comprises:
a compensation region (17) arranged adjacent to the drift region (11) and connected to the source contact (4).

7. The transistor device of any one of claims 4 to 6,
wherein each transistor cell (1) further comprises:
a JFET region (16) of the same doping type as the body region (13) and more highly doped than the body region (13),
wherein the JFET region is spaced apart from the gate dielectric (15) and adjoins at least one of the drift region (11) and the current spreading region (18).

8. The transistor device of claim 7,
wherein the JFET region (16) adjoins the source contact (4), and
wherein the body region (13) is connected to the source contact (14) through the JFET region (16).

9. A method comprising:
forming a plurality of trenches (2) in a first semiconductor layer (110) of a SiC semiconductor body (100), each trench (2) extending from a first surface (111) of the first semiconductor layer (110) into the first semiconductor layer (110);
forming source contacts (4), wherein each source contact is arranged in a respective one of the trenches (2) and is spaced apart from a bottom (2₃) of the respective trench (2); and
forming a plurality of transistor cells (1) such that each transistor cell (1) is coupled to a source node (S) via a respective source contact (4) and such that each transistor cell (1) is at least partially integrated in a respective one of a plurality of mesa regions (112) each formed between two neighboring ones of the trenches (2).

10. The method of claim 9,
wherein forming each transistor cell (1) comprises:
forming a source region (12) connected to the source contact (4); and
forming a body region (13) adjoining the source region (12),
wherein forming the source region (12) comprises forming a first implanted region (12') by implanting dopant atoms via the first surface (111) into the first semiconductor layer (110),
wherein forming the body region (13) comprises forming a second implanted region (12') by implanting dopant atoms via the first surface (111) into the first semiconductor layer (110), and
wherein forming the source region (12) and the body region (13) further comprises an annealing process.

11. The method of claim 10,
wherein forming each transistor cell (1) further comprises forming a JFET region (16), and
wherein forming the JFET (16) comprises forming a third implanted region (16') by implanting dopant atoms into the first semiconductor layer (110).

12. The method of claim 11,
wherein implanting the dopant atoms to form the third implanted region (16') comprises implanting the dopant atoms via a sidewall of a respective one of the trenches (2) into the first semiconductor layer (110).

13. The method of claim 12,
wherein implanting the dopant atoms via the sidewall comprises partially covering the sidewall by a protection layer (206).

14. The method of any one of claims 10 to 13,
wherein forming each transistor cell (1) further comprises forming a compensation region (17), and
wherein forming the compensation region (17) comprises forming a fourth implanted region (17') by implanting dopant atoms via a sidewall of a respective one of the trenches (2) into the first semiconductor layer (110).

15. The method of any one of claims 10 to 14,
wherein each transistor cell (1) further comprises a drift region (11), and
wherein forming the drift region (11) comprises forming a fifth implanted region (11') by implanting dopant atoms via a sidewall of a respective one of the trenches (2) into the first semiconductor layer (110).
